# EUROPEAN PATENT APPLICATION

(11) **EP 4 447 615 A1**
(43) Date of publication of application: **16.10.2024**
(21) Application number: 24166460.6
(22) Date of filing: 26.03.2024
(51) Int. Cl.: H05B 6/54, H05B 6/68, H05B 6/70, H05B 6/72, H05B 6/60, H05B 6/78, H05B 6/50

(54) **HEATING APPARATUS**

(30) Priority: 28.03.2023 JP 2023052013
(71) Applicant: Seiko Epson Corporation, Tokyo 160-8801 (JP)
(72) Inventor: AIZAWA, Tadashi, Suwa-shi 392-8502 (JP); YASHIRO, Hirotaka, Suwa-shi 392-8502 (JP); AOKI, Hiroki, Suwa-shi 392-8502 (JP); SASAKI, Tsuneyuki, Suwa-shi 392-8502 (JP)
(74) Representative: Lewis Silkin LLP

(57) **Abstract**

A heating apparatus includes a first electrode, a second electrode disposed surrounding the first electrode in plan view from a first direction toward a heating object, a first conductor including a coil and configured to electrically couple a transmission line and the first electrode, a second conductor configured to electrically couple the transmission line and the second electrode, and a housing. The first electrode and the second electrode are configured to heat the heating object by generating electromagnetic waves in response to application of a high-frequency voltage. The housing includes a contact part including a contact surface configured to come into contact with the heating object, and a housing case constituting an inner space configured to house the first electrode and the second electrode together with the contact part. The housing case has an insulating property.

## Description

The present application is based on, and claims priority from JP Application Serial Number 2023-052013, filed March 28, 2023, the disclosure of which is hereby incorporated by reference herein in its entirety.

### BACKGROUND

### 1. Technical Field

The present disclosure relates to a heating apparatus.

### 2. Related Art

For example, JP-A-2017-165000 discloses a heating apparatus that heats and dries a heating object by heating the heating object by generating electromagnetic waves to the heating object. Such a heating apparatus can perform drying without causing abnormal heating, spark or the like even when liquid containing a conductive material is used.

However, this heating apparatus uses electromagnetic waves with large heat energy. As such, it is desirable to suppress the influence of the generation of electromagnetic waves on the surroundings such as interference with the peripheral devices.

### SUMMARY

A heating apparatus for solving the above-described problems includes a first electrode, a second electrode disposed surrounding the first electrode in plan view from a first direction toward a heating object, a first conductor including a coil and configured to electrically couple a transmission line configured to transmit a high-frequency voltage and the first electrode, a second conductor configured to electrically couple the transmission line and the second electrode, and a housing covering at least a part of the first electrode and the second electrode, and at least a part of the first conductor and the second conductor, in which the first electrode and the second electrode are configured to heat the heating object by generating electromagnetic waves in response to application of a high-frequency voltage, the housing includes a contact part including a contact surface configured to come into contact with the heating object, and a housing case constituting an inner space configured to house the first electrode and the second electrode together with the contact part, and the housing case has an insulating property.

A heating apparatus for solving the above-described problems includes a contact part including a contact surface configured to come into contact with a heating object, a first electrode, a second electrode disposed surrounding the first electrode in plan view from a first direction toward the heating object, a first conductor including a coil and configured to electrically couple a transmission line configured to transmit a high-frequency voltage and the first electrode, a second conductor configured to electrically couple the transmission line and the second electrode, and an object detection unit configured to detect a contact of the contact part with the heating object, in which the first electrode and the second electrode are configured to heat the heating object by generating electromagnetic waves in response to application of a high-frequency voltage when the object detection unit detects the contact of the contact part with the heating object.

A heating apparatus for solving the above-described problems includes a contact part including a contact surface configured to come into contact with a heating object, a first electrode, a second electrode disposed surrounding the first electrode in plan view from a first direction toward the heating object, a first conductor including a coil and configured to electrically couple a transmission line configured to transmit a high-frequency voltage and the first electrode, a second conductor configured to electrically couple the transmission line and the second electrode, a temperature detection unit configured to detect a temperature, and a control unit, in which the first electrode and the second electrode are configured to heat the heating object by generating electromagnetic waves in response to application of a high-frequency voltage, and the control unit controls the generation of the electromagnetic waves by the first electrode and the second electrode based on a detection result of the temperature detection unit.

### BRIEF DESCRIPTION OF THE DRAWINGS

FIG. 1 is a schematic view illustrating a conveyance belt welding apparatus, a recording apparatus and a conveyance apparatus.
FIG. 2 is a block diagram illustrating the conveyance belt welding apparatus.
FIG. 3 is a perspective view illustrating an electromagnetic wave generation unit.
FIG. 4 is a perspective view illustrating the electromagnetic wave generation unit.
FIG. 5 is a perspective view illustrating the electromagnetic wave generation unit.
FIG. 6 is a bottom view illustrating the electromagnetic wave generation unit.
FIG. 7 is a flowchart illustrating contact monitoring processing.
FIG. 8 is a flowchart illustrating first temperature monitoring processing.
FIG. 9 is a perspective view illustrating the electromagnetic wave generation unit.
FIG. 10 is a perspective view illustrating the electromagnetic wave generation unit.
FIG. 11 is a flowchart illustrating second temperature monitoring processing.

### DESCRIPTION OF EMBODIMENTS

### First Embodiment

An embodiment of a conveyance belt welding apparatus as an example of a heating apparatus is described below. In the following description, the direction that intersects the vertical direction Z is the first horizontal direction X, and the direction that intersects the vertical direction Z and the first horizontal direction X is the second horizontal direction Y. One direction along the first horizontal direction X is the direction X1, and the other direction along the first horizontal direction X is the direction X2. One direction along the second horizontal direction Y is the direction Y1, and the other direction along the second horizontal direction Y is the direction Y2. The upward direction in the vertical direction Z is the upward direction Z1, and the downward direction in the vertical direction Z is the downward direction Z2. The downward direction Z2 is an example of the first direction. A plan view in the vertical direction Z may be a plan view in the upward direction Z1 or a plan view in the downward direction Z2. A plan view in the vertical direction Z is simply described as plan view.

### Configurations of Recording Apparatus 90 and Conveyance Apparatus 91

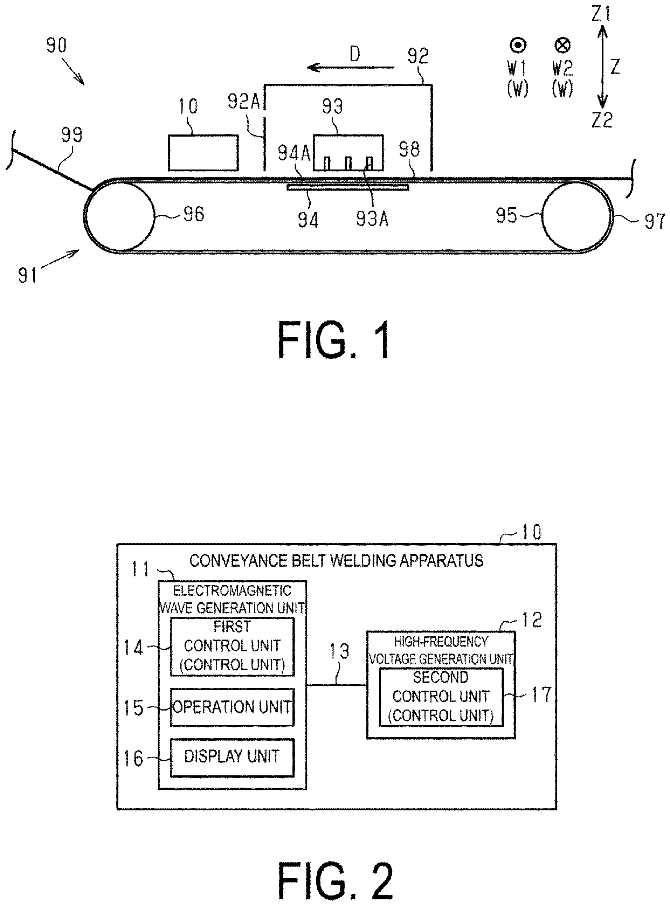

As illustrated in FIG. 1, a conveyance belt welding apparatus 10 can perform welding of conveyance belt 97. A conveyance belt 97 is an example of the heating object. The conveyance belt 97 may be used for the recording apparatus 90 and the conveyance apparatus 91.

The recording apparatus 90 is configured to perform recording on medium 99. The recording apparatus 90 may be an ink-jet printer that performs recording by ejecting ink as an example of liquid to the medium 99. The medium 99 is fabric, but may also be paper, for example.

The recording apparatus 90 includes an apparatus housing 92 and a recording unit 93. The apparatus housing 92 is configured to house at least the recording unit 93. The apparatus housing 92 may be configured to not house a first roller 95. Specifically, the first roller 95 may be exposed from the apparatus housing 92. The apparatus housing 92 may be configured to not house a second roller 96. Specifically, the second roller 96 may be exposed from the apparatus housing 92.

The apparatus housing 92 may include an opening/closing door 92A. The opening/closing door 92A may be provided on the side of a conveyance direction D of the medium 99 in the apparatus housing 92. The conveyance direction D is a direction along the longitudinal direction of the medium 99. The opening/closing door 92A is a door that can open and close the inside of the apparatus housing 92. Thus, the inside of the apparatus housing 92 can be accessed by opening the opening/closing door 92A. Specifically, by opening the opening/closing door 92A, a support surface 94A can be accessed. By opening the opening/closing door 92A, the conveyance belt welding apparatus 10 can be operated inside the apparatus housing 92.

The recording unit 93 is configured to perform recording on the medium 99 by ejecting liquid to the medium 99. The recording unit 93 performs recording on the medium 99 conveyed by the conveyance belt 97. The recording unit 93 performs recording on the medium 99 supported by the conveyance belt 97 and a support stand 94.

The recording unit 93 may be a head. The recording unit 93 may be a serial head or a line head. The serial head is a head that performs scanning in a width direction W of the medium 99. The line head is a head that simultaneously performs recording over the width direction W of the medium 99. One direction along the width direction W is a first width direction W1, and the other direction along the width direction W is a second width direction W2.

When the recording unit 93 is a serial head, it is disposed at an initial position when it does not perform the recording. The initial position may be located on the first width direction W1 side than the recording region. The initial position may be located on the first width direction W1 side than the conveyance belt 97. Specifically, when the recording unit 93 is a serial head, it is disposed at a position where it is does not interfere with the welding of the conveyance belt 97.

The recording unit 93 includes a plurality of nozzles 93A. Each of the plurality of nozzles 93A is configured to open in the downward direction Z2. Each of the plurality of nozzles 93A is configured to eject liquid.

The recording apparatus 90 includes the support stand 94. The support stand 94 is configured to support the medium 99 conveyed by the conveyance belt 97 together with the conveyance belt 97. The support stand 94 is located on the downward direction Z2 side of the recording unit 93. The support stand 94 may have a flat plate shape. The support stand 94 may be made of metal.

The support stand 94 includes the support surface 94A. The support surface 94A is a surface facing the upward direction Z1. The support surface 94A is located on the downward direction Z2 side of the recording unit 93. The support surface 94A is provided to face the plurality of nozzles 93A.

In this manner, the support stand 94 is configured to support the medium 99 conveyed by the conveyance belt 97 together with the conveyance belt 97. In addition, the support stand 94 may be configured to support the conveyance belt 97 when welding the conveyance belt 97. The member that supports the conveyance belt 97 when welding the conveyance belt 97 is not limited to the support stand 94.

The recording apparatus 90 includes the conveyance apparatus 91. The conveyance apparatus 91 is configured to convey the medium 99 in the conveyance direction D. The conveyance apparatus 91 may include a plurality of rollers. The conveyance apparatus 91 may include the first roller 95 and the second roller 96. The first roller 95 is located upstream of the second roller 96 in the conveyance direction D. The first roller 95 is located upstream of the recording unit 93 in the conveyance direction D. The second roller 96 is located downstream of the recording unit 93 in the conveyance direction D.

The conveyance apparatus 91 includes the conveyance belt 97. That is, the recording apparatus 90 includes the conveyance belt 97. The conveyance belt 97 can convey the medium 99. The conveyance belt 97 is configured to convey the medium 99 in the state of supporting the medium 99. The conveyance belt 97 is wound around a plurality of rollers. The conveyance belt 97 is wound around the first roller 95 and the second roller 96. When the first roller 95 rotates, the conveyance belt 97 moves along the first roller 95 and the second roller 96.

The conveyance belt 97 includes an outer peripheral surface 98. The conveyance belt 97 that supports the medium 99 is a belt with the outer peripheral surface 98 on which an adhesive is applied, for example. The medium 99 is bonded to the outer peripheral surface 98 with an adhesive. In this manner, the posture of the medium 99 is stabilized. The adhesive is not limitative, and the medium 99 may be bonded to the outer peripheral surface 98 with a suction force, an electrostatic force, an intermolecular force, and the like, for example.

In this manner, the conveyance belt 97 conveys the medium 99 supported by the outer peripheral surface 98 by moving along the first roller 95 and the second roller 96. The conveyance apparatus 91 conveys the medium 99 supported by the conveyance belt 97 by rotating at least one of the first roller 95 and the second roller 96.

The conveyance belt 97 may have a layered structure of a polyurethane material and an aramid material. The conveyance belt 97 can be welded by being heated at a predetermined temperature for a predetermined time in a state of being pressed with a predetermined pressure. Specifically, the conveyance belt 97 can be welded through heating of the polyurethane material. Deformation due to the welding of the conveyance belt 97 is suppressed by the pressing with a predetermined pressure.

The welding of the conveyance belt 97 includes coupling welding. The coupling welding is performed when replacing the conveyance belt 97 with an endless shape. The coupling welding is welding for forming the conveyance belt 97 with an endless shape by coupling the longitudinal both end portions of the conveyance belt 97. The coupling welding welds the longitudinal both end portions of the conveyance belt 97.

The longitudinal both end portions of the conveyance belt 97 may be obliquely cut along the width direction W in plan view. Specifically, the longitudinal both end portions of the conveyance belt 97 may be processed into a continuous V-shape along the width direction W in plan view. In this case, the coupling welding welds the longitudinal both end portions of the conveyance belt 97 with the longitudinal both end portions of the conveyance belt 97 stacked on each other in the direction along the conveyance direction D. In this manner, the welding area can be increased, and thus the welding quality of the conveyance belt 97 can be improved. In this manner, the conveyance accuracy of the conveyance belt 97 can be improved.

The welding of the conveyance belt 97 includes repair welding. The repair welding is performed when repairing the repair region of the conveyance belt 97. The repair region of the conveyance belt 97 is a part of the region of the conveyance belt 97 that needs to be repaired as it deteriorates over time.

### Configuration of Conveyance Belt Welding Apparatus 10

As illustrated in FIG. 2, the conveyance belt welding apparatus 10 includes an electromagnetic wave generation unit 11. The conveyance belt welding apparatus 10 may include a high-frequency voltage generation unit 12. The conveyance belt welding apparatus 10 may include a transmission line 13.

The electromagnetic wave generation unit 11 is configured to generate electromagnetic waves. The electromagnetic wave generation unit 11 generates an alternating current electric field through generation of electromagnetic waves. The electromagnetic wave generation unit 11 heats the conveyance belt 97 through generation of electromagnetic waves. The electromagnetic wave generation unit 11 can weld the conveyance belt 97 through heating. The main component of the electromagnetic waves generated by the electromagnetic wave generation unit 11 is an electric field. The electromagnetic wave generation unit 11 can significantly reduce the induction of the magnetic field due to the generated electric field in comparison with electromagnetic wave generation units that generate typical electromagnetic waves.

As a specific example, the electromagnetic wave generation unit 11 generates electromagnetic waves of 2.4 GHz, but this is not limitative. The electromagnetic wave generation unit 11 may generate electromagnetic waves of 3 MHz to 300 MHz, for example. The electromagnetic wave generation unit 11 may generate electromagnetic waves of 300 MHz to 30 GHz, or more specifically electromagnetic waves of 10 MHz to 20 GHz, for example.

The conveyance belt welding apparatus 10 includes a control unit. The control unit controls the conveyance belt welding apparatus 10. Specifically, the electromagnetic wave generation unit 11 may include a first control unit 14 as the control unit. The first control unit 14 controls the electromagnetic wave generation unit 11. The first control unit 14 controls various operations executed at the electromagnetic wave generation unit 11.

The control unit may be configured as a circuit including α: one or more processors that execute various processing in accordance with a computer program, β: one or more dedicated hardware circuits that execute at least part of the various processing, or γ: their combinations. The hardware circuit is an application-specific integrated circuit, for example. The processor includes a CPU and a memory such as a RAM and a ROM, and the memory stores program codes or commands configured to cause the CPU to execute processing. The memory, i.e., a computer readable medium includes any readable mediums that can be accessed by general-purpose or dedicated computers.

The electromagnetic wave generation unit 11 may include an operation unit 15. The operation unit 15 is operable by the operator. The operation unit 15 may allow for an operation related to the conveyance belt welding apparatus 10. The operation unit 15 may allow for an operation related to the electromagnetic wave generation unit 11. The operation unit 15 may allow for an operation related to the high-frequency voltage generation unit 12. The operation unit 15 may allow for an operation of switching whether to generate electromagnetic waves from the electromagnetic wave generation unit 11.

The electromagnetic wave generation unit 11 may include a display unit 16. The display unit 16 may display information related to the conveyance belt welding apparatus 10. The operation unit 15 may display information related to the electromagnetic wave generation unit 11. The operation unit 15 may display information related to the high-frequency voltage generation unit 12. The display unit 16 may display information representing whether electromagnetic waves are being generated from the electromagnetic wave generation unit 11. The display unit 16 may be a liquid crystal display unit, or an LED lamp.

The high-frequency voltage generation unit 12 is configured to generate a high-frequency voltage. The high-frequency voltage generation unit 12 can supply a high-frequency voltage to the electromagnetic wave generation unit 11 through the transmission line 13. Specifically, the high-frequency voltage generation unit 12 generates the voltage to be applied to the electromagnetic wave generation unit 11.

The high-frequency voltage generation unit 12 may include a second control unit 17 as the control unit. The second control unit 17 controls the high-frequency voltage generation unit 12. The second control unit 17 controls various operations executed at the high-frequency voltage generation unit 12. The first control unit 14 and the second control unit 17 may exchange information. The conveyance belt welding apparatus 10 includes both the first control unit 14 and the second control unit 17 as the control unit, but the conveyance belt welding apparatus 10 may include one of them.

Note that the conveyance belt welding apparatus 10 may include an operation unit that can be operated at the high-frequency voltage generation unit 12 separately from the operation unit 15 of the electromagnetic wave generation unit 11. The conveyance belt welding apparatus 10 may include a display unit that displays information at the high-frequency voltage generation unit 12 separately from the display unit 16 of the electromagnetic wave generation unit 11.

The transmission line 13 is a line that couples the electromagnetic wave generation unit 11 and the high-frequency voltage generation unit 12. The transmission line 13 is a line for transmitting the high-frequency voltage generated by the high-frequency voltage generation unit 12 to the electromagnetic wave generation unit 11. That is, the transmission line 13 can transmit a high-frequency voltage.

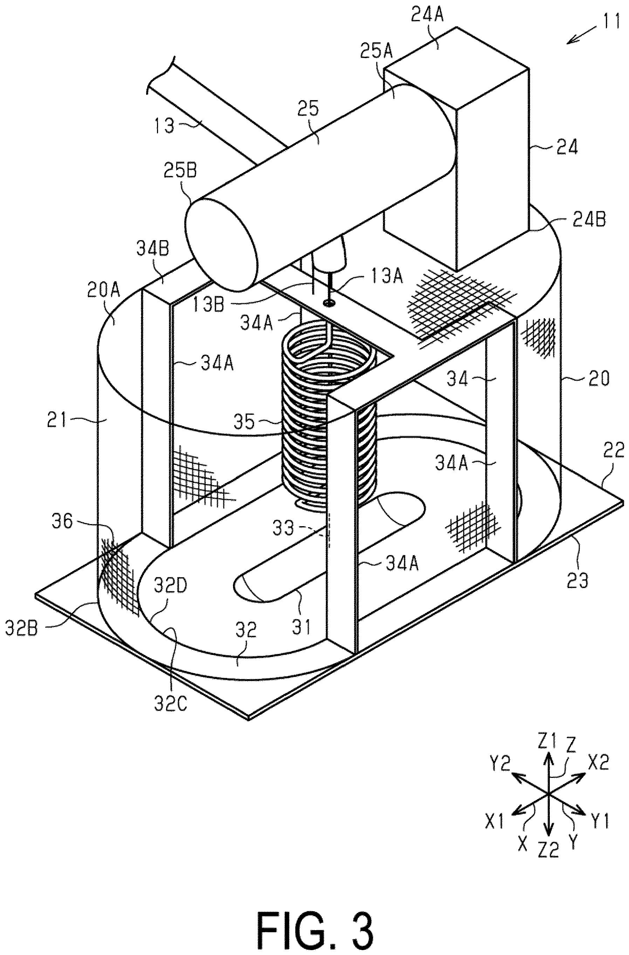

The transmission line 13 may be, but not limited to, a coaxial cable. As illustrated in FIG. 3, the transmission line 13 may include an inner conductor 13A and an outer conductor 13B. The inner conductor 13A may include a core wire of the transmission line 13. The outer conductor 13B may be an electromagnetic shield that covers the inner conductor 13A. The inner conductor 13A corresponds to an example of the first transmission line, and the outer conductor 13B corresponds to an example of the second transmission line.

### Configuration of Electromagnetic Wave Generation Unit 11

As illustrated in FIG. 3, the electromagnetic wave generation unit 11 includes a housing 20. The housing 20 constitutes the inner space of the electromagnetic wave generation unit 11. The housing 20 can house various members constituting the electromagnetic wave generation unit 11. That is, the housing 20 covers at least some of various members constituting the electromagnetic wave generation unit 11. Specifically, the housing 20 may cover a first electrode 31, a second electrode 32, a first conductor 33 and a second conductor 34. In this manner, no direct contact with the first electrode 31, the second electrode 32, the first conductor 33 and the second conductor 34 is made from the outside of the housing 20. The inner space is a space that can house at least the first electrode 31 and the second electrode 32.

The housing 20 may include a housing case 21. That is, the conveyance belt welding apparatus 10 may include the housing case 21. The housing 20 includes a contact part 22. That is, the conveyance belt welding apparatus 10 includes the contact part 22. The housing case 21 is composed of a material with transmissivity, and therefore only an end portion is illustrated in FIG. 3.

The housing case 21 constitutes the inner space of the electromagnetic wave generation unit 11 together with the contact part 22. The housing case 21 can house various members constituting the electromagnetic wave generation unit 11. The housing case 21 has a rounded rectangular shape in plan view, but the shape is not limited and may be a rectangular shape, for example. The rounded rectangular shape is composed of two straight lines and two curved lines. The two straight lines are extended in the first horizontal direction X and disposed side by side in the second horizontal direction Y. The two curved lines are located on both sides in the first horizontal direction X. The rounded rectangular shape may be a shape like an athletic track.

The housing case 21 is composed of an insulating member. The housing case 21 may be made of resin. The housing case 21 is coupled to the contact part 22. The housing case 21 extends from the contact part 22 in the upward direction Z1. In this manner, the housing case 21 is provided covering the first electrode 31, the second electrode 32, the first conductor 33 and the second conductor 34 from the upward direction Z1 side. That is, the housing case 21 can house the first electrode 31, the second electrode 32, the first conductor 33 and the second conductor 34.

At least a part of the housing case 21 may have transmissivity. The housing case 21 may be a transparent plastic case. In this manner, the inside of the conveyance belt welding apparatus 10 can be visually recognized from the outside.

The contact part 22 is located on the downward direction Z2 side of the housing case 21. The contact part 22 may have a flat plate shape. The contact part 22 has a rectangular shape in plan view, but the shape is not limited, and may have a rounded rectangular shape, for example. The contact part 22 may have a rectangular shape with the sides along the first horizontal direction X longer than the sides along the second horizontal direction Y in plan view. The contact part 22 is provided covering the first electrode 31, the second electrode 32, the first conductor 33 and the second conductor 34 from the downward direction Z2 side.

The contact part 22 is composed of a material that transmits electromagnetic waves generated by the first electrode 31 and the second electrode 32. The contact part 22 is pressed with the conveyance belt 97 in contact with a contact surface 23 when welding the conveyance belt 97. As such, the contact part 22 may be made of a material with a certain degree of hardness. In addition, the contact part 22 protects the first electrode 31, the second electrode 32, the first conductor 33 and the second conductor 34. Specifically, the contact part 22 protects the first electrode 31, the second electrode 32, the first conductor 33 and the second conductor 34 also from the stress caused by the pressing of the conveyance belt 97.

The contact part 22 is composed of an insulating member. The contact part 22 may be a glass plate. Specifically, at least a part of the contact part 22 may have transmissivity. In this manner, the region of the conveyance belt 97 in contact with the contact part 22 can be visually recognized, in whole or in part, from the outside of the conveyance belt welding apparatus 10. The contact part 22 may be a ceramic with high transparency. The contact part 22 may be a resin with low dielectric loss tangent.

The contact part 22 includes the contact surface 23. The contact surface 23 is a surface facing the downward direction Z2 side. The contact surface 23 can come into contact with the conveyance belt 97 when welding the conveyance belt 97. When the conveyance belt welding apparatus 10 is used with the conveyance belt 97 supported at the support stand 94, the contact surface 23 can come into contact with the conveyance belt 97 with the conveyance belt 97 sandwiched between it and the support stand 94.

The electromagnetic wave generation unit 11 may include a coupling part 24 and a holding part 25. The coupling part 24 may be composed of an insulating member. The coupling part 24 may be made of resin. The coupling part 24 extends along the vertical direction Z. The coupling part 24 includes an upper end portion 24A and a lower end portion 24B. The upper end portion 24A is coupled to the holding part 25. The lower end portion 24B is coupled to a top surface 20A of the housing 20. The lower end portion 24B may be located at the other direction X2 side in the first horizontal direction X in the top surface 20A of the housing 20.

The holding part 25 is a portion that can be gripped by the operator. The holding part 25 is composed of an insulating member such as resin, but may be made of metal, for example. The holding part 25 may extend along the first horizontal direction X. The holding part 25 may extend in one direction X1 in the first horizontal direction X. The holding part 25 includes a base end portion 25A and a tip end portion 25B. The base end portion 25A is coupled to the upper end portion 24A of the coupling part 24. That is, the holding part 25 is coupled to the housing case 21 and insulated from the housing case 21.

The holding part 25 is provided at a position separated from the top surface 20A of the housing 20 in the upward direction Z1. The holding part 25 is provided at a position separated from the contact part 22 in the upward direction Z1. In addition, the holding part 25 is provided at a position separated from the first electrode 31 and the second electrode 32 in the upward direction Z1. The holding part 25 may be provided with the operation unit 15. The holding part 25 may be provided with the display unit 16.

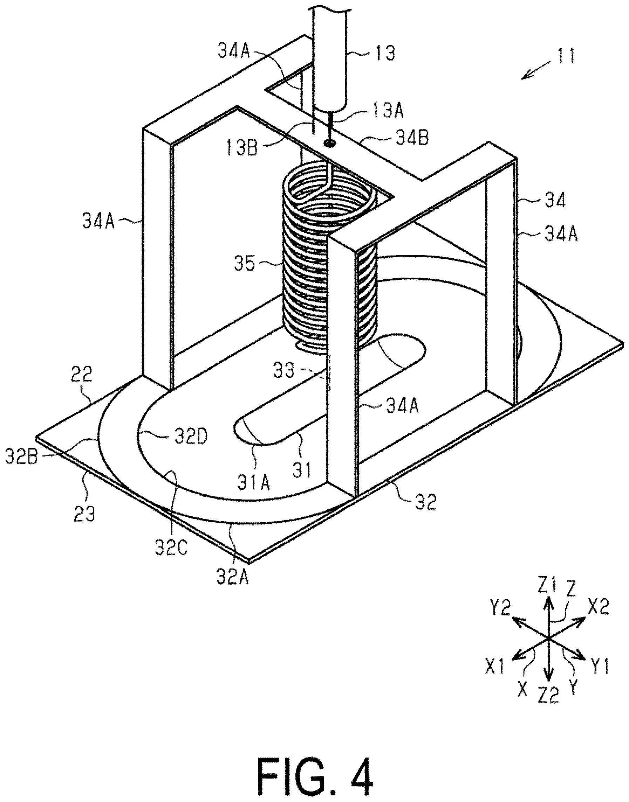

As illustrated in FIGS. 3 and 4, the electromagnetic wave generation unit 11 includes the first electrode 31, the second electrode 32, the first conductor 33, and the second conductor 34. The first electrode 31 has a flat plate shape. The first electrode 31 may have a rounded rectangular shape elongated in the first horizontal direction X in plan view.

The first electrode 31 includes a first electrode surface 31A. The first electrode surface 31A is a surface facing the downward direction Z2 side. The first electrode surface 31A is a surface parallel to the contact surface 23. That is, the first electrode surface 31A is a surface facing the conveyance belt 97 when welding the conveyance belt 97. In other words, the first electrode surface 31A is a surface facing the conveyance belt 97 side when welding the conveyance belt 97.

The second electrode 32 has a flat plate shape. The second electrode 32 includes a second electrode surface 32A. The second electrode surface 32A is a surface facing the downward direction Z2 side. The second electrode surface 32A is a surface parallel to the contact surface 23. That is, the second electrode surface 32A is a surface facing the conveyance belt 97 when welding the conveyance belt 97. In other words, the second electrode surface 32A is a surface facing the conveyance belt 97 side when welding the conveyance belt 97.

The second electrode 32 has a rounded rectangular shape at an outer periphery 32B in plan view. The outer periphery 32B is located inside the inner wall of the housing case 21. That is, the second electrode 32 is housed inside the housing case 21 in plan view. In this manner, the first electrode 31 and the second electrode 32 are covered with the housing case 21.

The second electrode 32 includes an opening 32C. The opening 32C has a rounded rectangular shape in plan view. That is, the second electrode 32 has a rounded rectangular shape at an inner periphery 32D in plan view. The second electrode 32 is disposed surrounding the first electrode 31 in plan view. The downward direction Z2 is the direction toward the conveyance belt 97 when welding the conveyance belt 97.

The first electrode 31 is provided such that the first electrode surface 31A faces the contact part 22. The second electrode 32 is provided such that the second electrode surface 32A faces the contact part 22. In this manner, the contact part 22 is provided to face the first electrode surface 31A and the second electrode surface 32A between the first electrode surface 31A and the second electrode surface 32A, and the conveyance belt 97 when welding the conveyance belt 97.

The first electrode 31 and the second electrode 32 are provided such that the first electrode surface 31A and the second electrode surface 32A come into contact with the contact part 22. The first electrode 31 and the second electrode 32 may be provided such that a gap is formed between the first electrode surface 31A and the second electrode surface 32A, and the contact part 22.

The first electrode 31 and the second electrode 32 are provided such that the first electrode surface 31A and the second electrode surface 32A are included in the contact surface 23 in plan view. Specifically, the first electrode 31 and the second electrode 32 are covered with the contact part 22 as viewed from the downward direction Z2. In this manner, the conveyance belt 97 and the contact surface 23 come into contact with each other when welding the conveyance belt 97, and thus the first electrode 31 and the second electrode 32 are protected from the contact with the conveyance belt 97.

The first electrode 31 and the second electrode 32 are covered with the housing 20, and thus are not exposed from the housing 20. In this manner, the first electrode 31 and the second electrode 32 are provided so as not to come into contact with the peripheral devices and the operator.

The first conductor 33 is configured to electrically couple the transmission line 13 and the first electrode 31. Specifically, the first conductor 33 is configured to electrically couple the inner conductor 13A and the first electrode 31. The first conductor 33 includes a coil 35. The coil 35 extends in the vertical direction Z.

The second conductor 34 is configured to electrically couple the transmission line 13 and the second electrode 32. Specifically, the second conductor 34 is configured to electrically couple the outer conductor 13B and the second electrode 32.

The second conductor 34 may include a first supporting part 34A. The second conductor 34 may include a plurality of the first supporting parts 34A. The second conductor 34 may include a second supporting part 34B.

The first supporting part 34A is electrically coupled to the second electrode 32. The first supporting part 34A extends in the upward direction Z1 from the second electrode 32. The first supporting part 34A may have a flat plate shape. The first supporting part 34A may have the same width as the second electrode 32 in the second horizontal direction Y. The first supporting part 34A may have a flat plate shape with a small thickness with respect to the first horizontal direction X. The first supporting part 34A is configured to be short in the first horizontal direction X, and long in the vertical direction Z to maintain the distance from the first electrode 31 and the second electrode 32 in the vertical direction Z while ensuring the rigidity. The first supporting part 34A may be made of metal. The first supporting part 34A is configured to support the second supporting part 34B.

The second supporting part 34B is electrically coupled to the first supporting part 34A. The second supporting part 34B is provided at the upper end portion of the first supporting part 34A. The second supporting art 34B may be integrated with the first supporting part 34A. The second supporting part 34B may have a flat plate shape. The second supporting part 34B may have a flat plate shape with a small thickness with respect to the vertical direction Z. The second supporting part 34B may have an H-shape in plan view. The second supporting part 34B may be made of metal.

The second conductor 34 may include a shield part 36. The shield part 36 is configured to seamlessly cover the first electrode 31 and the second electrode 32 from the upward direction Z1 side. The shield part 36 has a function of suppressing the propagation of electromagnetic waves from the first electrode 31 and the second electrode 32. The shield part 36 has a net shape, and therefore a part of the shield part 36 is illustrated in a net-shaped pattern in FIG. 3.

The shield part 36 is electrically coupled to the second electrode 32. The shield part 36 is in line contact with the second electrode 32, but may be in point contact with the second electrode 32. The shield part 36 is provided surrounding the entire region of the outer periphery 32B of the second electrode 32 in plan view. The shield part 36 extends in the upward direction Z1 from the second electrode 32.

The shield part 36 is electrically coupled to the first supporting part 34A. The shield part 36 may be located outside the first supporting part 34A. The shield part 36 is electrically coupled to the second supporting part 34B. The shield part 36 may be located on the upward direction Z1 side of the second supporting part 34B. The shield part 36 is supported by the first supporting part 34A and the second supporting part 34B.

The shield part 36 may be provided at a position separated by a predetermined distance from the inner wall of the housing case 21. In other words, the housing case 21 may be provided at a position separated by a predetermined distance from the outer wall of the shield part 36. In this manner, the housing case 21 covers the first electrode 31, the second electrode 32, the first conductor 33 and the second conductor 34. The predetermined distance may be a distance with which the parasitic capacitance generated between the housing case 21 and the shield part 36 is a predetermined capacitance or smaller.

The shield part 36 may be made of metal. The shield part 36 may have a net shape. In this manner, the second conductor 34 may have a net shape in whole or in part. Specifically, at least a part of the second conductor 34 may have transmissivity. In addition, contrary to the shield part 36, the first supporting part 34A and the second supporting part 34B are composed in a minimum size to increase the visibility while ensuring the rigidity of the shield part 36.

With the electromagnetic wave generation unit 11 configured in this manner, the first electrode 31 and the second electrode 32 heat the conveyance belt 97 by generating electromagnetic waves in response to the application of the high-frequency voltage when a high-frequency voltage is applied through the transmission line 13. The first electrode 31 and the second electrode 32 can weld the conveyance belt 97 by heating the conveyance belt 97 at a predetermined temperature for a predetermined time. By pressing the conveyance belt 97 against the support stand 94 with the contact surface 23 in contact with the conveyance belt 97, the conveyance belt 97 is pressed at a predetermined pressure between the contact surface 23 and the support stand 94.

This electromagnetic wave generation unit 11 can transmit a large heat energy to the conveyance belt 97 through the generation of electromagnetic waves. As a specific example, the electromagnetic wave generation unit 11 can transmit a large heat energy of 100 W to 500 W to the conveyance belt 97 by generating electromagnetic waves to heat the conveyance belt 97 to approximately 160 degrees.

The electromagnetic wave generation unit 11 is an electromagnetic wave system, not a heat conduction system, and therefore may not include members such as electric heating wires for heating. In this manner, the electromagnetic wave generation unit 11 can be downsized. In this manner, the conveyance belt 97 can be welded by the electromagnetic wave generation unit 11 by using the extra space of the recording apparatus 90 without disassembling the apparatus housing 92 of the recording apparatus 90.

In addition, the electromagnetic wave generation unit 11 has a size that can be gripped by the operator with one hand. The electromagnetic wave generation unit 11 is smaller than the width of the conveyance belt 97 although it depends on the size of the conveyance belt 97. In addition, it has a weight that can be moved in the state of being gripped by the operator along with the welding of the conveyance belt 97, and can press the conveyance belt 97.

In addition, the minimum distance between the first electrode 31 and the second electrode 32 is 1/10 or smaller of the wavelength of the electromagnetic waves output from the electromagnetic wave generation unit 11. In this manner, most of electromagnetic waves that are generated in the application of the high-frequency voltage can be attenuated in the vicinity of the first electrode 31 and the second electrode 32. In this manner, the intensity of the electromagnetic waves that reach remote locations from the first electrode 31 and the second electrode 32 can be reduced. Specifically, the electromagnetic waves generated from the electromagnetic wave generation unit 11 are very strong in the vicinity of the first electrode 31 and the second electrode 32, but are very weak at a remote location.

This electromagnetic wave generation unit 11 can intensively generate the alternating current electric field in the vicinity of the first electrode 31 and the second electrode 32 when the frequency band of the generated electromagnetic waves is appropriately controlled. In other words, the influence of the generation of electromagnetic waves on the surroundings beyond the vicinity of the first electrode 31 and the second electrode 32 can be suppressed. The vicinity of the first electrode 31 and the second electrode 32 may correspond to a range of 3 mm to 3 cm, for example.

### Operations and Effects of First Embodiment

Operations and effects of the first embodiment are described below.

(1-1) In some situation replacement of the conveyance belt 97 becomes necessary due to age-related deterioration. In such case, in the related art, in replacement of the conveyance belt 97, the conveyance belt 97 is welded by heating the conveyance belt 97 in a sandwiched and pressed state. However, this results in the increase in the size of the conveyance belt welding apparatus provided with the above-mentioned function. In particular, since the conveyance belt 97 is heated by the heat conduction system with no generation of electromagnetic waves, electric heating wires for heating and metal members for heat conduction have to be used, resulting in the increase in the size of the conveyance belt welding apparatus. As a result, the operation efficiency is reduced regardless of whether conveying the conveyance belt welding apparatus to the installation position of the recording apparatus, or conveying the recording apparatus to the installation position of the conveyance belt welding apparatus. In addition, the recording apparatus does not have the space for using the conveyance belt welding apparatus. This requires disassembly of the recording apparatus when using known conveyance belt welding apparatuses. This also reduces the operation efficiency.

In view of this, the first electrode 31 and the second electrode 32 weld the conveyance belt 97 by generating electromagnetic waves in response to the application of the high-frequency voltage. With this configuration, by generating electromagnetic waves in response to the application of the high-frequency voltage, high heat energy can be transmitted to the conveyance belt 97. Thus, the efficiency of the operation related to the welding of the conveyance belt 97 can be improved while ensuring the conveyance accuracy of the conveyance belt 97.

(1-2) In addition, when an electromagnetic wave system of generating electromagnetic waves is employed, the electromagnetic wave generation unit 11 can be downsized by comparison with the heat conduction system of not generating electromagnetic waves. In this manner, by reducing the size of the electromagnetic wave generation unit 11, it can be moved by being gripped by the operator without the necessity of disassembling the apparatus housing 92 of the recording apparatus 90. Thus, the efficiency of the operation related to the welding of the conveyance belt 97 can be improved.

(1-3) The housing case 21 constitutes the inner space together with the contact part 22, and has an insulating property. In this manner, the first electrode 31 and the second electrode 32 can be housed in the inner space by using the contact part 22 and the housing case 21, and the direct contact of the first electrode 31 and the second electrode 32 with the surroundings can be suppressed. In addition, the insulating property from the first electrode 31 and the second electrode 32 can be ensured. Thus, the influence of the generation of electromagnetic waves on the surroundings can be suppressed.

Specifically, the electromagnetic wave generation unit 11 is downsized and can be gripped by the operator, and thus further remarkable effects are provided. In addition, the first electrode 31 and the second electrode 32 are very small relative to the wavelength of the electromagnetic waves. In this manner, with the housing case 21 configured such that peripheral devices with a size close to the wavelength of the electromagnetic waves do not come into contact with the first electrode 31 and the second electrode 32, the influence of the generation of electromagnetic waves on the surroundings can be suppressed.

(1-4) The holding part 25 that can be gripped by the operator is also insulated from the housing case 21. In this manner, the insulating property of the holding part 25, and the first electrode 31 and the second electrode 32 can be further ensured. Thus, the influence of the generation of electromagnetic waves on the surroundings can be suppressed.

(1-5) The holding part 25 is provided at a position separated from the first electrode 31 and the second electrode 32 than the housing case 21. In this manner, the distance between the holding part 25, and the first electrode 31 and the second electrode 32 can be ensured. Thus, the influence of the generation of electromagnetic waves on the surroundings can be suppressed. In particular, no problem occurs even when the holding part 25 is gripped by the operator with bare hands, and the influence of the generation of electromagnetic waves can be suppressed.

(1-6) In the related art, the heat conduction system is used, and the conveyance belt 97 is heated in the state where the conveyance belt 97 is pressed with the conveyance belt 97 sandwiched by a metal plate. As such, the region for heating the conveyance belt 97 is covered with the metal plate, and the welding state of the conveyance belt 97 cannot be visually recognized.

In view of this, at least a part of the housing case 21 has transmissivity, and at least a part of the contact part 22 has transmissivity. With this configuration, the visibility of the region of the conveyance belt 97 in contact with the contact surface 23 can be improved through the housing case 21 and the contact part 22. In this manner, the welding state of the region of the conveyance belt 97 in contact with the contact surface 23 can be easily visually recognized. Thus, the efficiency of the operation related to the welding of the conveyance belt 97 can be improved.

In addition, since the welding state of the conveyance belt 97 is a delicate operation, the welding quality of the conveyance belt 97 can be improved by improving the visibility of the welding region of the conveyance belt 97.

Specifically, when the welding state of the conveyance belt 97 can be visually recognized in the case where the repair welding of the conveyance belt 97 is performed, the welding quality of the conveyance belt 97 can be improved, and the efficiency of the operation related to the welding of the conveyance belt 97 can be improved.

(1-7) The second conductor 34 has a net shape in whole or in part. With this configuration, through the second conductor 34 housed in the housing case 21, the visibility of the region of the conveyance belt 97 in contact with the contact surface 23 can be improved. In this manner, the welding state of the region of the conveyance belt 97 in contact with the contact surface 23 can be easily visually recognized. Thus, the efficiency of the operation related to the welding of the conveyance belt 97 can be improved.

### Second Embodiment

Next, a second embodiment is described. In the following description, the overlapping description of the same configurations as those of the above-described embodiment will be omitted or simplified, and the configurations different from those of the above-described embodiment will be mainly described.

### Configuration of Electromagnetic Wave Generation Unit 11

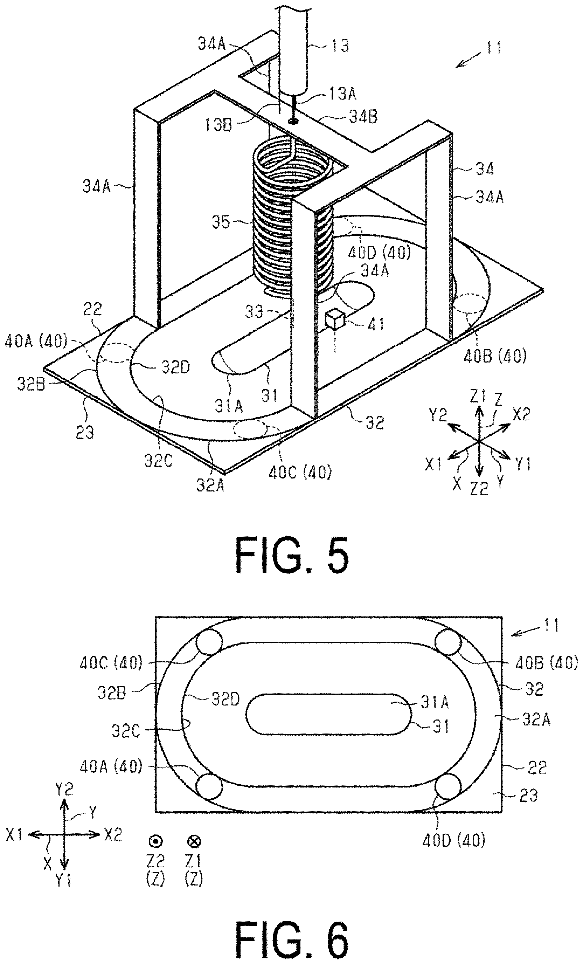

As illustrated in FIGS. 5 and 6, in the second embodiment, the electromagnetic wave generation unit 11 may include an object detection unit 40. The object detection unit 40 may be provided in the contact part 22. The object detection unit 40 may be provided in the contact part 22 and form a horizontal plane with the contact surface 23. The object detection unit 40 may be provided on the downward direction Z2 side of the second electrode surface 32A, while the object detection unit 40 may be provided on the outside than the outer periphery 32B of the second electrode 32.

The object detection unit 40 detects a contact of the contact surface 23 with the heating object. The conveyance belt 97 as an example of the heating object is parallel to the contact surface 23. As such, it can be said that the object detection unit 40 detects whether the heating object is disposed along the contact surface 23. In this manner, the object detection unit 40 detects a contact of the contact part 22 with the conveyance belt 97.

The electromagnetic wave generation unit 11 may include a plurality of pressure sensors as the object detection unit 40. The plurality of pressure sensors may include a first pressure sensor 40A and a second pressure sensor 40B. That is, the electromagnetic wave generation unit 11 may include the first pressure sensor 40A and the second pressure sensor 40B. The plurality of pressure sensors may include a third pressure sensor 40C and a fourth pressure sensor 40D.

The plurality of pressure sensors can detect a contact of the contact part 22 with the heating object. The plurality of pressure sensors may be coupled to the first control unit 14. The first control unit 14 receives a detection signal from each of the plurality of pressure sensors. In this manner, the first control unit 14 can acquire the detection result of each of the plurality of pressure sensors based on the detection signal.

The electromagnetic wave generation unit 11 may include a temperature detection unit 41. The temperature detection unit 41 detects the temperature. The temperature detection unit 41 may be a temperature sensor. The temperature detection unit 41 may detect the temperature of a predetermined region in the conveyance belt 97. The predetermined region may be a region between the first electrode surface 31A and the second electrode surface 32A in plan view. Specifically, the predetermined region is a region that is heated through generation of electromagnetic waves from the first electrode 31 and the second electrode 32. In this manner, the temperature detection unit 41 detects the temperature of the conveyance belt 97.

The temperature detection unit 41 may be coupled to the first control unit 14. The first control unit 14 receives a detection signal from the temperature detection unit 41. In this manner, the first control unit 14 can acquire the detection result of the temperature detection unit 41 based on the detection signal.

### Contact Monitoring Processing

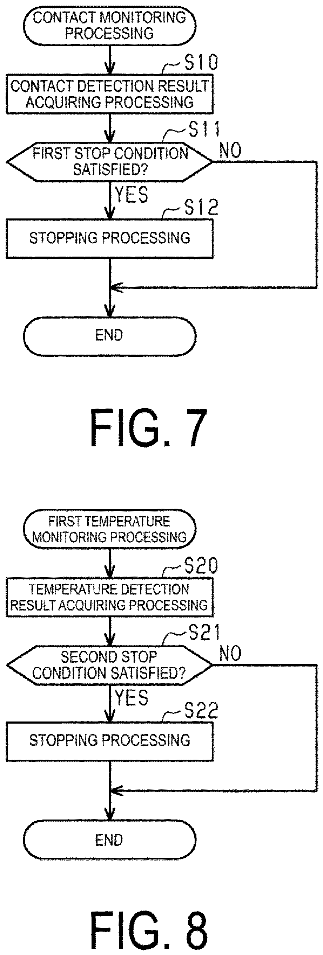

Contact monitoring processing is described below with reference to FIG. 7. The contact monitoring processing is processing executed by the first control unit 14 for each predetermined cycle. The contact monitoring processing may be processing executed by the first control unit 14 for each predetermined cycle when electromagnetic waves are being generated, or processing executed by the first control unit 14 for each predetermined cycle before electromagnetic waves are generated.

As illustrated in FIG. 7, at step S10, the first control unit 14 executes contact detection result acquiring processing. In the contact detection result acquiring processing, the first control unit 14 acquires a contact detection result based on the detection signal from the object detection unit 40. The contact detection result is a detection result regarding whether the object detection unit 40 is in contact with the heating object. The contact detection result may be a result regarding whether each of the plurality of pressure sensors is in contact with the heating object. When step S10 is completed, the first control unit 14 advances the processing to step S11.

At step S11, the first control unit 14 determines whether a first stop condition is satisfied. The first stop condition is satisfied when the object detection unit 40 detects that the contact surface 23 is not in contact with the heating object. The first stop condition is satisfied when it is detected that at least one of the plurality of pressure sensors is not in contact with the heating object. That is, the first stop condition is not satisfied when it is detected that all of the plurality of pressure sensors are not in contact with the heating object. The first stop condition is not limited to a condition that is satisfied when it is detected that at least one of the plurality of pressure sensors is not in contact with the heating object. The first stop condition may be satisfied when it is detected that all of the plurality of pressure sensors are not in contact with the heating object, and may not be satisfied when it is detected that at least one of the plurality of pressure sensors is in contact, for example.

When determining that the first stop condition is not satisfied, the first control unit 14 terminates the contact monitoring processing without executing step S12. In this manner, when determining that the first stop condition is not satisfied, the first control unit 14 can continuously generate electromagnetic waves. When determining that the first stop condition is satisfied, the first control unit 14 advances the processing to step S12.

At step S12, the first control unit 14 executes stopping processing. In the stopping processing, the first control unit 14 stops the generation of electromagnetic waves. In this manner, when determining that the first stop condition is satisfied, the first control unit 14 stops the generation of electromagnetic waves. When step S12 is completed, the first control unit 14 terminates the contact monitoring processing.

In this manner, the first control unit 14 can heat the heating object by generating electromagnetic waves in response to the application of the high-frequency voltage when the object detection unit 40 detects a contact of the contact part 22 with the heating object. In other words, the first electrode 31 and the second electrode 32 can heat the heating object by generating electromagnetic waves in response to the application of the high-frequency voltage when the object detection unit 40 detects a contact of the contact part 22 with the heating object. On the other hand, when the object detection unit 40 detects that the contact part 22 is not in contact with the heating object, the first electrode 31 and the second electrode 32 do not generate electromagnetic waves in response to the application of the high-frequency voltage. That is, the first control unit 14 controls the generation of electromagnetic waves by the first electrode 31 and the second electrode 32 based on the detection result of the object detection unit 40.

### First Temperature Monitoring Processing

First temperature monitoring processing is described below with reference to FIG. 8. The first temperature monitoring processing is processing executed by the first control unit 14 for each predetermined cycle. The first temperature monitoring processing may be processing executed by the first control unit 14 for each predetermined cycle when electromagnetic waves are being generated.

As illustrated in FIG. 8, at step S20, the first control unit 14 executes temperature detection result acquiring processing. In the temperature detection result acquiring processing, the first control unit 14 acquires the temperature detection result based on the detection signal from the temperature detection unit 41. The temperature detection result is the detection result of the temperature of the heating object. When step S20 is completed, the first control unit 14 advances the processing to step S21.

At step S21, the first control unit 14 determines whether a second stop condition is satisfied. The second stop condition may be satisfied when the temperature of the conveyance belt 97 acquired at step S20 becomes equal to or greater than the threshold value. The threshold value may be the temperature of the conveyance belt 97 that can be estimated to be abnormal when electromagnetic waves are being generated. Specifically, the first control unit 14 can determine whether there is occurrence of an abnormality based on the temperature of the conveyance belt 97 when electromagnetic waves are being generated. In other words, the first control unit 14 can determine whether there is occurrence of an abnormality based on whether the temperature of the conveyance belt 97 is an acceptable temperature when electromagnetic waves are being generated. The acceptable temperature of the conveyance belt 97 is the temperature of the conveyance belt 97 that is estimated to be normal based on the output information.

When determining that the second stop condition is not satisfied, the first control unit 14 terminates the first temperature monitoring processing without executing step S22. In this manner, when determining that the second stop condition is not satisfied, the first control unit 14 can continuously generate electromagnetic waves. When determining that the second stop condition is satisfied, the first control unit 14 advances the processing to step S22.

At step S22, the first control unit 14 executes the stopping processing. In the stopping processing, the first control unit 14 stops the generation of electromagnetic waves. In this manner, when determining that the second stop condition is satisfied, the first control unit 14 can stop the generation of electromagnetic waves. When step S22 is completed, the first control unit 14 terminates the first temperature monitoring processing.

In this manner, the first control unit 14 controls the generation of electromagnetic waves by the first electrode 31 and the second electrode 32 based on the detection result of the temperature detection unit 41. Specifically, the first control unit 14 stops the generation of electromagnetic waves by the first electrode 31 and the second electrode 32 based on the detection result of the temperature detection unit 41. Specifically, when the temperature detected by the temperature detection unit 41 exceeds a threshold value, the first control unit 14 performs a control to stop the generation of electromagnetic waves by the first electrode 31 and the second electrode 32.

### Operations and Effects of Second Embodiment

Operations and effects of the second embodiment are described below.

(2-1) When it is detected that the contact part 22 is in contact with the heating object, the first electrode 31 and the second electrode 32 can heat the heating object by generating electromagnetic waves in response to the application of the high-frequency voltage. With this configuration, electromagnetic waves can be generated with the contact part 22 in contact with the heating object. Thus, the influence of the generation of electromagnetic waves on the surroundings can be suppressed.

(2-2) The object detection unit 40 includes the first pressure sensor 40A and the second pressure sensor 40B, and the first pressure sensor 40A and the second pressure sensor 40B can detect a contact of the contact part 22 with the heating object. With this configuration, electromagnetic waves can be generated with the contact part 22 in contact with the heating object based on the detection result of the first pressure sensor 40A and the detection result of the second pressure sensor 40B. In this manner, the contact between the contact part 22 and the heating object can be detected at a plurality of locations. In this manner, the reliability of the detection of the contact between the contact part 22 and the heating object can be increased. Thus, the influence of the generation of electromagnetic waves on the surroundings can be suppressed.

(2-3) The first control unit 14 controls the generation of electromagnetic waves by the first electrode 31 and the second electrode 32 based on the detection result of the temperature detection unit 41. With this configuration, the generation of electromagnetic waves can be controlled based on the detection result of the temperature detection unit 41. Thus, the influence of the generation of electromagnetic waves on the surroundings can be suppressed.

(2-4) The temperature detection unit 41 detects the temperature of the heating object. With this configuration, the generation of electromagnetic waves can be controlled based on the detection result of the temperature of the heating object. Thus, the influence of the generation of electromagnetic waves on the surroundings can be suppressed.

(2-5) When the temperature detected by the temperature detection unit 41 exceeds a threshold value, the first control unit 14 performs a control to stop the generation of electromagnetic waves by the first electrode 31 and the second electrode 32. With this configuration, the generation of electromagnetic waves can be stopped when the detected temperature exceeds a threshold value. Thus, the influence of the generation of electromagnetic waves on the surroundings can be suppressed.

### Third Embodiment

Next, a third embodiment is described.

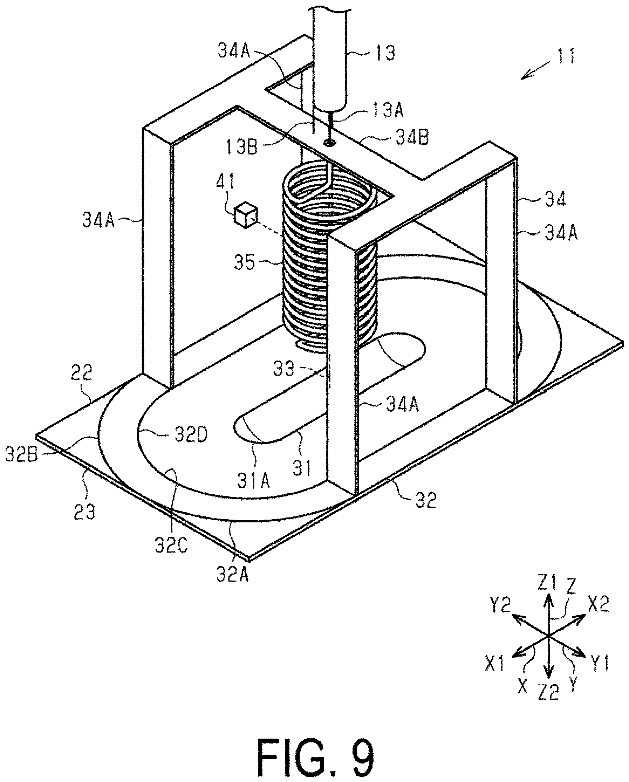

As illustrated in FIG. 9, in the third embodiment, the temperature detection unit 41 may detect the temperature of the coil 35, not the temperature of the conveyance belt 97. In the third embodiment, the first control unit 14 may execute the first temperature monitoring processing as in the second embodiment. In this case, the temperature detection result acquired at step S20 is the detection result of the temperature of the coil 35. The second stop condition at step S21 may be satisfied when the temperature of the coil 35 acquired at step S20 becomes equal to or greater than a predetermined threshold value. The threshold value may be the temperature of the coil 35 that can be estimated to be abnormal when electromagnetic waves are being generated. Specifically, the first control unit 14 can determine whether there is occurrence of an abnormality based on the temperature of the coil 35 when electromagnetic waves are being generated.

### Operations and Effects of Third Embodiment

Operations and effects of the third embodiment are described below.

(3-1) In the conveyance belt 97, the dielectric loss tangent decreases as the temperature rises. The dielectric loss tangent represents the heating efficiency characteristics for the electromagnetic waves. Therefore, the conveyance belt 97 has a characteristic that the heating efficiency of electromagnetic waves decreases as the temperature rises. In this manner, when the conveyance belt 97 is excessively heated, the heat energy is less transmitted to the conveyance belt 97, and the voltage applied to the parasitic resistance of the coil 35 correspondingly increases, thus increasing the temperature of the coil 35.

In view of this, the temperature detection unit 41 detects the temperature of the coil 35. With this configuration, the generation of electromagnetic waves can be controlled based on the detection result of the temperature of the coil 35. Thus, the influence of the generation of electromagnetic waves on the surroundings can be suppressed.

### Fourth Embodiment

Next, a fourth embodiment is described.

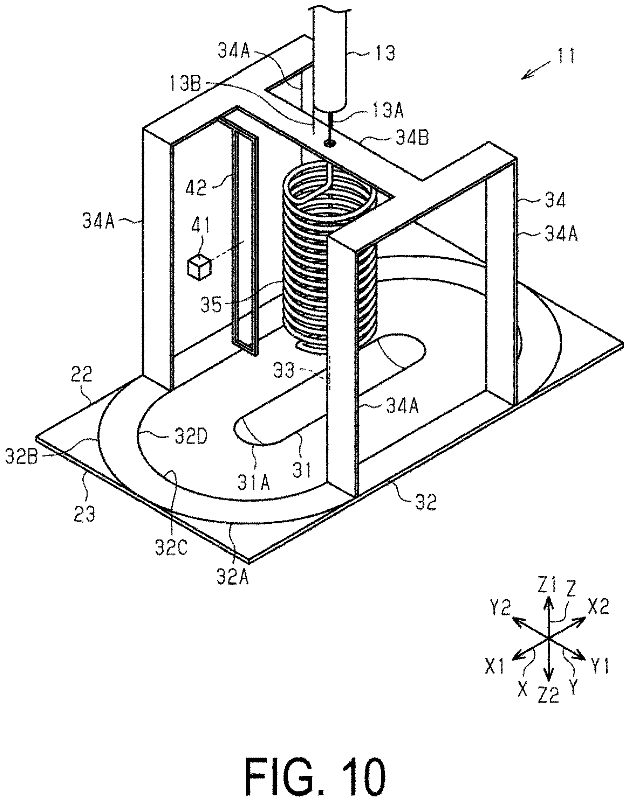

As illustrated in FIG. 10, in the fourth embodiment, an electromagnetic clamp 42 is provided. The electromagnetic clamp 42 may be electrically coupled to the second conductor 34. In other words, the electromagnetic clamp 42 may be provided in the outer conductor 13B through the second conductor 34. That is, the electromagnetic clamp 42 may be provided in the transmission line 13. The temperature detection unit 41 may detect the temperature of the electromagnetic clamp 42, not the temperatures of the conveyance belt 97 and the coil 35.

In the fourth embodiment, the first control unit 14 may execute the first temperature monitoring processing as in the third embodiment. In this case, the temperature detection result acquired at step S20 is the detection result of the temperature of the electromagnetic clamp 42. The second stop condition at step S21 may be satisfied when the temperature of the electromagnetic clamp 42 acquired at step S20 becomes equal to or greater than a predetermined threshold value. This threshold value may be the temperature of the electromagnetic clamp 42 that can be estimated to be abnormal when electromagnetic waves are being generated. Specifically, the first control unit 14 can determine whether there is occurrence of an abnormality based on the temperature of the electromagnetic clamp 42 when electromagnetic waves are being generated.

### Operations and Effects of Fourth Embodiment

Operations and effects of the fourth embodiment are described below.

(4-1) When the conveyance belt 97 is excessively heated, the heat energy is less transmitted to the conveyance belt 97, and the temperature of the electromagnetic clamp 42 increases. In view of this, the temperature detection unit 41 detects the temperature of the electromagnetic clamp 42 provided in the transmission line 13. With this configuration, the generation of electromagnetic waves can be controlled based on the detection result of the temperature of the electromagnetic clamp 42. Thus, the influence of the generation of electromagnetic waves on the surroundings can be suppressed.

### Fifth Embodiment

Next, a fifth embodiment is described.

In the fifth embodiment, the electromagnetic wave generation unit 11 includes the temperature detection unit 41 that detects the temperature of the conveyance belt 97 as in the second embodiment. Further, it is possible to estimate that the heat energy due to the generation of electromagnetic waves is transmitted to other peripheral devices than the conveyance belt 97 when the actually detected temperature is lower than the temperature corresponding to the intensity of electromagnetic waves generated by the electromagnetic wave generation unit 11.

### Second Temperature Monitoring Processing

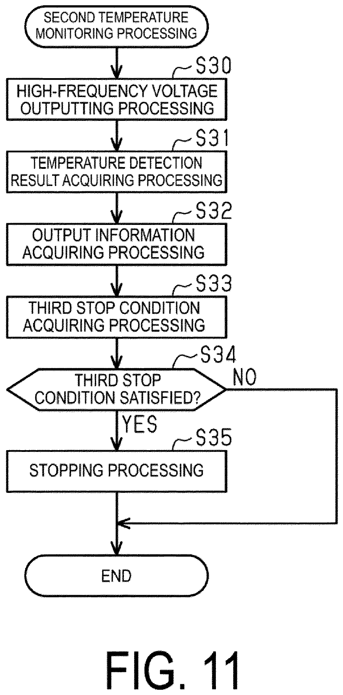

Now, second temperature monitoring processing is described with reference to FIG. 11. The second temperature monitoring processing is processing executed by the second control unit 17 for each predetermined cycle. The second temperature monitoring processing may be processing executed by the second control unit 17 for each predetermined cycle when generating electromagnetic waves.

As illustrated in FIG. 11, at step S30, the second control unit 17 executes high-frequency voltage outputting processing. The second control unit 17 outputs a high-frequency voltage to the electromagnetic wave generation unit 11. Specifically, the second control unit 17 outputs a high-frequency voltage to the electromagnetic wave generation unit 11 such that the conveyance belt 97 is set to a constant temperature. When step S30 is completed, the second control unit 17 advances the processing to step S31.

At step S31, the second control unit 17 executes the temperature detection result acquiring processing. In the temperature detection result acquiring processing, the second control unit 17 acquires the temperature detection result based on the detection signal from the temperature detection unit 41. The second control unit 17 may acquire the temperature detection result based on the detection signal from the temperature detection unit 41 through communications with the first control unit 14. The temperature detection result is the detection result of the temperature of the heating object. When step S31 is completed, the second control unit 17 advances the processing to step S32.

At step S32, the second control unit 17 executes an output information acquiring processing. In the output information acquiring processing, the second control unit 17 acquires output information. The output information may be information representing a high-frequency voltage that is being applied to the electromagnetic wave generation unit 11. Specifically, it can be said that the output information is information related to an estimated information temperature that is estimated that the temperature of the conveyance belt 97 increases through generation of electromagnetic waves. When step S32 is completed, the second control unit 17 advances the processing to step S33.

At step S33, the second control unit 17 executes third stop condition acquiring processing. In the third stop condition acquiring processing, the second control unit 17 acquires a third stop condition corresponding to the acquired output information. The third stop condition is a condition related to the acceptable temperature of the conveyance belt 97. The third stop condition may be a condition related to the temperature variation of the conveyance belt 97, or a condition related to the temperature of the conveyance belt 97 itself. Specifically, the third stop condition may be a condition related to a lower limit threshold value of the temperature variation of the conveyance belt 97. When the temperature variation of the conveyance belt 97 becomes equal to or smaller than the lower limit threshold value corresponding to the output information, it is possible to estimate that the heat energy of the generated electromagnetic waves is being transmitted to other peripheral devices than the conveyance belt 97 and the like.

The second control unit 17 may acquire the third stop condition by reading from the memory the third stop condition corresponding to the acquired output information. In this manner, the second control unit 17 can acquire the third stop condition corresponding to the intensity of electromagnetic waves that are being generated. When step S33 is completed, the second control unit 17 advances the processing to step S34.

At step S34, the second control unit 17 determines whether the third stop condition is satisfied. When determining that the third stop condition is not satisfied, the second control unit 17 terminates the second temperature monitoring processing without executing step S35. In this manner, when determining that the third stop condition is not satisfied, the second control unit 17 can continuously generate electromagnetic waves. When determining that the third stop condition is satisfied, the second control unit 17 advances the processing to step S35.

At step S35, the second control unit 17 executes the stopping processing. In the stopping processing, the second control unit 17 stops the generation of electromagnetic waves. In this manner, when determining that the third stop condition is satisfied, the second control unit 17 stops the generation of electromagnetic waves. When step S35 is completed, the second control unit 17 terminates the second temperature monitoring processing.

In this manner, the second control unit 17 performs a control to stop the generation of electromagnetic waves by the first electrode 31 and the second electrode 32 based on the detection result of the temperature detection unit 41 and the high-frequency voltage applied to the first electrode 31 and the second electrode 32. Specifically, when the temperature detected by the temperature detection unit 41 exceeds a lower limit threshold value, the second control unit 17 performs a control to stop the generation of electromagnetic waves by the first electrode 31 and the second electrode 32.

### Operations and Effects of Fifth Embodiment

Operations and effects of the fifth embodiment are described below.

(5-1) The second control unit 17 controls the high-frequency voltage applied to the first electrode 31 and the second electrode 32 based on the detection result of the temperature detection unit 41 and the high-frequency voltage applied to the first electrode 31 and the second electrode 32. With this configuration, the high-frequency voltage applied to the first electrode 31 and the second electrode 32 can be controlled based on the detection result of the temperature detection unit 41 and the high-frequency voltage applied to the first electrode 31 and the second electrode 32. In this manner, the high-frequency voltage control can be performed based on both the temperature detected by the temperature detection unit 41 and the high-frequency voltage applied to the first electrode 31 and the second electrode 32. Thus, the influence of the generation of electromagnetic waves on the surroundings can be suppressed.

(5-2) When the variation of the temperature detected by the temperature detection unit 41 becomes equal to or lower than the lower limit variation corresponding to the high-frequency voltage, the second control unit 17 stops the generation of electromagnetic waves by the first electrode 31 and the second electrode 32. With this configuration, leakage of the heat energy of the generated electromagnetic waves can be detected, and the generation of electromagnetic waves can be stopped when leakage of heat energy is detected. Thus, the influence of the generation of electromagnetic waves on the surroundings can be suppressed.

### Modifications

The embodiments may be modified as follows for implementation. The embodiments and modifications described below may be combined for implementation insofar as they are not technically inconsistent.

In the second embodiment, the object detection unit 40 may include a temperature sensor that detects the temperature of the heating object. In this case, the object detection unit 40 may include a temperature sensor as the temperature detection unit 41. In addition, the object detection unit 40 may include a temperature sensor instead of the third pressure sensor 40C and the fourth pressure sensor 40D. Specifically, the object detection unit 40 may include the temperature detection unit 41, and a temperature sensor that detects the temperature of the conveyance belt 97.

When the temperature of the heating object is within the temperature range corresponding to the heating object, the object detection unit 40 may detect that the contact surface 23 is in contact with the heating object. As a specific example, when the temperature detected by the temperature sensor is not within the temperature range corresponding to the conveyance belt 97 upon the start of the generation of electromagnetic waves, the first control unit 14 may detect that the contact surface 23 is not in contact with the heating object. When the temperature detected by the temperature sensor is within the temperature range upon the start of the generation of electromagnetic waves, the first control unit 14 may detect that the contact surface 23 is in contact with the heating object.

The first control unit 14 generates electromagnetic waves for a predetermined time, but when the variation of the temperature detected by the temperature detection unit 41 is not within the range of the variation corresponding to the conveyance belt 97, it may detect that the contact surface 23 is not in contact with the heating object. The first control unit 14 generates electromagnetic waves for a predetermined time, but when the variation of the temperature detected by the temperature detection unit 41 is within the range of the variation corresponding to the conveyance belt 97, it may detect that the contact surface 23 is in contact with the heating object.

In this manner, the object detection unit 40 includes a temperature sensor that detects the temperature of the heating object. With this configuration, electromagnetic waves can be generated with the contact part 22 in contact with the heating object based on the detection result of the temperature sensor. Thus, the influence of the generation of electromagnetic waves on the surroundings can be suppressed.

In the second embodiment, when the first stop condition is satisfied, the first control unit 14 may control the intensity of electromagnetic waves generated to be small without stopping the generation of electromagnetic waves. Specifically, the first control unit 14 may control the high-frequency voltage applied to the first electrode 31 and the second electrode 32 based on the detection result of the object detection unit 40.

In the second to fourth embodiments, when the second stop condition is satisfied, the first control unit 14 may control the intensity of electromagnetic waves generated to be small without stopping the generation of electromagnetic waves. Specifically, the first control unit 14 may control the high-frequency voltage applied to the first electrode 31 and the second electrode 32 based on the detection result of the temperature detection unit 41.

In the fifth embodiment, the second control unit 17 may repeatedly execute the second temperature monitoring processing in a predetermined period. In this case, at step S30, the second control unit 17 may perform a feedback-control of a high-frequency voltage such that the conveyance belt 97 is set to a constant temperature based on the temperature detection result acquired at step S31 and the output information acquired at step S32. Specifically, the second control unit 17 may control the high-frequency voltage applied to the first electrode 31 and the second electrode 32 based on the detection result of the temperature detection unit 41 and the high-frequency voltage applied to the first electrode 31 and the second electrode 32.

The first control unit 14 may continue the generation of electromagnetic waves when the resonance frequency of the electromagnetic waves generated by the first electrode 31 and the second electrode 32 is within an acceptable frequency. The first control unit 14 may stop the generation of electromagnetic waves when the resonance frequency of the electromagnetic waves generated by the first electrode 31 and the second electrode 32 is not within the acceptable frequency. The first control unit 14 may control the intensity of electromagnetic waves generated to be small when the resonance frequency of the electromagnetic waves generated by the first electrode 31 and the second electrode 32 is not within the acceptable frequency. The acceptable frequency is a resonance frequency range with respect to the resonance frequency corresponding to the heating object, and is a resonance frequency range allowing for generation of electromagnetic waves to the heating object. In the electromagnetic wave generation unit 11, the resonance frequency of the electromagnetic waves generated from the first electrode 31 and the second electrode 32 varies depending on the physical property of the heating object. Specifically, the capacitance between the first electrode 31 and the second electrode 32, and the heating object differs depending on the physical property of the heating object. In addition, the heating resistance differs depending on the physical property of the heating object. As such, when the capacitance decreases, the resonance frequency increases. In this manner, the generated resonance frequency of the electromagnetic waves varies depending on the physical property of the heating object. In view of this, the first control unit 14 can generate electromagnetic waves to the heating object by continuing the generation of the electromagnetic waves by determining the generation of electromagnetic waves to the heating object when it is close to the resonance frequency corresponding to the heating object.

In the second to fourth embodiments, the processing executed by the first control unit 14 may be executed by the second control unit 17. In this case, the second control unit 17 may acquire a variety of information through communications with the first control unit 14, or directly acquire a variety of information not through communications with the first control unit 14. In the fifth embodiment, the processing executed by the second control unit 17 may be executed by the first control unit 14. In this case, the first control unit 14 may instruct the high-frequency voltage generation unit 12 whether to output the high-frequency voltage, or may instruct the high-frequency voltage that is to be output.

In plan view, the housing case 21 may be located inside the outer periphery 32B of the second electrode 32 as long as it is located outside the inner periphery 32D of the second electrode 32. In plan view, the shield part 36 is located inside the housing case 21, but it may be located inside the outer periphery 32B of the second electrode 32 as long as it is located outside the inner periphery 32D of the second electrode 32. The shield part 36 may have a plate shape instead of the net shape.

The contact part 22 may not come into surface contact with the conveyance belt 97 but may come into point contact with the conveyance belt 97 as long as the distance between the first electrode 31 and the second electrode 32, and the conveyance belt 97 is within a predetermined range.

The contact part 22 may not come into surface contact with the first electrode 31 and the second electrode 32, but may come into point contact with the first electrode 31 and the second electrode 32 as long as the distance between the first electrode 31 and the second electrode 32, and the conveyance belt 97 is within a predetermined range. In addition, the contact part 22 may not come into contact with the first electrode 31 and the second electrode 32.

At least one of the first electrode 31 and the second electrode 32 is not limited to the flat plate shape, and may have a substantially flat plate shape, for example. The substantially flat plate shape may include a shape curved in the thickness direction as the direction along the vertical direction Z, and a linear shape as a rectangular shape with very large aspect ratio, for example.

The heating object is not limited to the conveyance belt 97 as long as it generates heat through generation of electromagnetic waves and transmission of the heat energy. For example, the heating apparatus may be a drying apparatus that dries ink by heating the medium 99.

The recording apparatus 90 may be a laser printer that records images by attaching toner by using laser light. Specifically, the recording system of the recording apparatus 90 is not limited, and may be an ink-jet system or a laser system.

The expression "at least one of" used in the specification means one or more of desired options. As an example, when the number of options is two, the expression "at least one of" used in the specification means only one option or both of the two options. As another example, when the number of options is three or more, the expression "at least one of" used in the specification means only one option or any combination of two or more options.

### Supplementary Notes

The following is a description of the technical ideas and their effects that can be grasped from the above-described embodiments and modifications. This technical concept and its effects can be combined with each other to the extent that they are not technically inconsistent.
(A) A heating apparatus includes a first electrode, a second electrode disposed surrounding the first electrode in plan view from a first direction toward a heating object, a first conductor including a coil and configured to electrically couple a transmission line configured to transmit a high-frequency voltage and the first electrode, a second conductor configured to electrically couple the transmission line and the second electrode, and a housing covering at least a part of the first electrode and the second electrode, and at least a part of the first conductor and the second conductor. The first electrode and the second electrode are configured to heat the heating object by generating electromagnetic waves in response to application of a high-frequency voltage, the housing includes a contact part including a contact surface configured to come into contact with the heating object, and a housing case constituting an inner space configured to house the first electrode and the second electrode together with the contact part, and the housing case has an insulating property.

With this configuration, the housing case constitutes the inner space together with the contact part and has an insulating property. In this manner, the first electrode and the second electrode can be housed in the inner space by using the contact part and the housing case, and the first electrode and the second electrode can be prevented from making direct contact with the surroundings. In addition, the insulating property from the first electrode and the second electrode can be ensured. Thus, the influence of the generation of electromagnetic waves on the surroundings can be suppressed.

(B) The above-described heating apparatus may further include a holding part configured to be gripped by an operator, and the holding part may be coupled to the housing case, and insulated from the housing case.

With this configuration, the holding part coupled to the housing case also has an insulating property from the housing case. In this manner, the insulating property of the holding part gripped by the operator and the first and second electrodes can be further ensured. Thus, the influence of the generation of electromagnetic waves on the surroundings can be suppressed.

(C) The above-described heating apparatus may further include an object detection unit configured to detect a contact of the contact part with the heating object, and the first electrode and the second electrode may be configured to heat the heating object by generating electromagnetic waves in response to the application of the high-frequency voltage when the object detection unit detects the contact of the contact part with the heating object.

With this configuration, electromagnetic waves can be generated with the contact part in contact with the heating object. Thus, the influence of the generation of electromagnetic waves on the surroundings can be suppressed.

(D) A heating apparatus includes a contact part including a contact surface configured to come into contact with a heating object, a first electrode, a second electrode disposed surrounding the first electrode in plan view from a first direction toward the heating object, a first conductor including a coil and configured to electrically couple a transmission line configured to transmit a high-frequency voltage and the first electrode, a second conductor configured to electrically couple the transmission line and the second electrode, and an object detection unit configured to detect a contact of the contact part with the heating object. The first electrode and the second electrode are configured to heat the heating object by generating electromagnetic waves in response to application of a high-frequency voltage when the object detection unit detects the contact of the contact part with the heating object. With this configuration, the same effect as that of (C) can be achieved.

(E) In the above-described heating apparatus, the object detection unit may include a first pressure sensor and a second pressure sensor, and the first pressure sensor and the second pressure sensor may be configured to detect the contact of the contact part with the heating object.

With this configuration, electromagnetic waves can be generated with the contact part in contact with the heating object based on the detection result of the first pressure sensor and the detection result of the second pressure sensor. In this manner, the contact between the contact part and the heating object can be detected at a plurality of locations. In this manner, the reliability of the detection of the contact between the contact part and the heating object can be increased. Thus, the influence of the generation of electromagnetic waves on the surroundings can be suppressed.

(F) In the above-described heating apparatus, the object detection unit may include a temperature sensor configured to detect a temperature of the heating object.

With this configuration, electromagnetic waves can be generated with the contact part in contact with the heating object based on the detection result of the temperature sensor. Thus, the influence of the generation of electromagnetic waves on the surroundings can be suppressed.

(G) The above-described heating apparatus may further include a temperature detection unit configured to detect a temperature, and a control unit. The control unit may control the generation of the electromagnetic waves by the first electrode and the second electrode based on a detection result of the temperature detection unit.

With this configuration, the generation of electromagnetic waves can be controlled with the contact part in contact with the heating object based on the detection result of the temperature detection unit. Thus, the influence of the generation of electromagnetic waves on the surroundings can be suppressed.

(H) A heating apparatus includes a contact part including a contact surface configured to come into contact with a heating object, a first electrode, a second electrode disposed surrounding the first electrode in plan view from a first direction toward a heating object, a first conductor including a coil and configured to electrically couple a transmission line configured to transmit a high-frequency voltage and the first electrode, a second conductor configured to electrically couple the transmission line and the second electrode, a temperature detection unit configured to detect a temperature, and a control unit, the first electrode and the second electrode are configured to heat the heating object by generating electromagnetic waves in response to application of a high-frequency voltage, and the control unit controls the generation of the electromagnetic waves by the first electrode and the second electrode based on a detection result of the temperature detection unit. With this configuration, the same effect as that of (G) can be achieved.

(I) In the above-described heating apparatus, the temperature detection unit may detect a temperature of the heating object.

With this configuration, the generation of electromagnetic waves can be controlled with the contact part in contact with the heating object based on the detection result of the temperature of the heating object. Thus, the influence of the generation of electromagnetic waves on the surroundings can be suppressed.

(J) In the above-described heating apparatus, the temperature detection unit may detect a temperature of the coil.

With this configuration, the generation of electromagnetic waves can be controlled with the contact part in contact with the heating object based on the detection result of the temperature of the coil. Thus, the influence of the generation of electromagnetic waves on the surroundings can be suppressed.

(K) In the above-described heating apparatus, the temperature detection unit may detect a temperature of an electromagnetic clamp provided in the transmission line.

With this configuration, the generation of electromagnetic waves can be controlled with the contact part in contact with the heating object based on the detection result of the temperature of the electromagnetic clamp. Thus, the influence of the generation of electromagnetic waves on the surroundings can be suppressed.

(L) In the above-described heating apparatus, the control unit may control a high-frequency voltage to be applied to the first electrode and the second electrode based on the detection result of the temperature detection unit and the high-frequency voltage to be applied to the first electrode and the second electrode.

With this configuration, the high-frequency voltage to be applied to the first electrode and the second electrode can be controlled based on the detection result of the temperature detection unit and the high-frequency voltage to be applied to the first electrode and the second electrode. In this manner, the high-frequency voltage can be controlled based on both the temperature detected by the temperature detection unit, and the high-frequency voltage to be applied to the first electrode and the second electrode. Thus, the influence of the generation of electromagnetic waves on the surroundings can be suppressed.

(M) In the above-described heating apparatus, when a temperature detected by the temperature detection unit exceeds a threshold value, the control unit may perform a control to stop the generation of the electromagnetic waves by the first electrode and the second electrode.

With this configuration, the generation of electromagnetic waves can be stopped when the detected temperature exceeds a threshold value. Thus, the influence of the generation of electromagnetic waves on the surroundings can be suppressed.

## Claims

1. A heating apparatus comprising:
a first electrode;
a second electrode disposed surrounding the first electrode in plan view from a first direction toward a heating object;
a first conductor including a coil and configured to electrically couple a transmission line configured to transmit a high-frequency voltage and the first electrode;
a second conductor configured to electrically couple the transmission line and the second electrode; and
a housing covering at least a part of the first electrode and the second electrode, and at least a part of the first conductor and the second conductor, wherein
the first electrode and the second electrode are configured to heat the heating object by generating electromagnetic waves in response to application of a high-frequency voltage,
the housing includes
a contact part including a contact surface configured to come into contact with the heating object and
a housing case constituting an inner space configured to house the first electrode and the second electrode together with the contact part, and
the housing case has an insulating property.

2. The heating apparatus according to claim 1, further comprising
a holding part configured to be gripped by an operator, wherein
the holding part is coupled to the housing case, and insulated from the housing case.

3. The heating apparatus according to claim 1, further comprising
an object detection unit configured to detect a contact of the contact part with the heating object, wherein
the first electrode and the second electrode are configured to heat the heating object by generating electromagnetic waves in response to the application of the high-frequency voltage when the object detection unit detects the contact of the contact part with the heating object.

4. A heating apparatus comprising:
a contact part including a contact surface configured to come into contact with a heating object;
a first electrode;
a second electrode disposed surrounding the first electrode in plan view from a first direction toward the heating object;
a first conductor including a coil and configured to electrically couple a transmission line configured to transmit a high-frequency voltage and the first electrode;
a second conductor configured to electrically couple the transmission line and the second electrode; and
an object detection unit configured to detect a contact of the contact part with the heating object, wherein
the first electrode and the second electrode are configured to heat the heating object by generating electromagnetic waves in response to application of a high-frequency voltage when the object detection unit detects the contact of the contact part with the heating object.

5. The heating apparatus according to claim 3, wherein
the object detection unit includes a first pressure sensor and a second pressure sensor and
the first pressure sensor and the second pressure sensor are configured to detect the contact of the contact part with the heating object.

6. The heating apparatus according to claim 3, wherein
the object detection unit includes a temperature sensor configured to detect a temperature of the heating object.

7. The heating apparatus according to claim 1, further comprising:
a temperature detection unit configured to detect a temperature; and
a control unit, wherein
the control unit controls the generation of the electromagnetic waves by the first electrode and the second electrode based on a detection result of the temperature detection unit.

8. A heating apparatus comprising:
a contact part including a contact surface configured to come into contact with a heating object;
a first electrode;
a second electrode disposed surrounding the first electrode in plan view from a first direction toward the heating object;
a first conductor including a coil and configured to electrically couple a transmission line configured to transmit a high-frequency voltage and the first electrode;
a second conductor configured to electrically couple the transmission line and the second electrode;
a temperature detection unit configured to detect a temperature; and
a control unit, wherein
the first electrode and the second electrode are configured to heat the heating object by generating electromagnetic waves in response to application of a high-frequency voltage and
the control unit controls the generation of the electromagnetic waves by the first electrode and the second electrode based on a detection result of the temperature detection unit.

9. The heating apparatus according to claim 7, wherein
the temperature detection unit detects a temperature of the heating object.

10. The heating apparatus according to claim 7, wherein
the temperature detection unit detects a temperature of the coil.

11. The heating apparatus according to claim 7, wherein
the temperature detection unit detects a temperature of an electromagnetic clamp provided in the transmission line.

12. The heating apparatus according to claim 7, wherein
the control unit controls a high-frequency voltage to be applied to the first electrode and the second electrode based on the detection result of the temperature detection unit and the high-frequency voltage to be applied to the first electrode and the second electrode.

13. The heating apparatus according to claim 7, wherein
when a temperature detected by the temperature detection unit exceeds a threshold value, the control unit performs a control to stop the generation of the electromagnetic waves by the first electrode and the second electrode.
